# EUROPEAN PATENT APPLICATION

(11) **EP 1 308 312 A1**
(43) Date of publication of application: **07.05.2003**
(21) Application number: 01954499.8
(22) Date of filing: 07.08.2001
(51) Int. Cl.: B41N 1/14

(54) **THERMO-SENSITIVE RECORDING TYPE LITHOGRAPHICAL BLOCK MATERIAL, METHOD OF MAKING UP LITHOGRAPHICAL BLOCK, AND LITHOGRAPHICAL BLOCK MADE UP BY THE MAKING UP METHOD**

(30) Priority: 09.08.2000 JP 2000241442
(71) Applicant: Labo Co., Ltd, Kanagawa 243-0426 (JP); NOF CORPORATION, Tokyo 150-6019 (JP)
(72) Inventor: YAMAMOTO, Hideyuki, c/o LABO CO., LTD., Ebina-shi, Kanagawa 243-0426 (JP); SATO, Koji, Chita-gun, Aichi 470-2504 (JP); ISHIDOYA, Masahiro, Chigasaki-shi, Kanagawa 253-0061 (JP)
(74) Representative: Pacitti, Paolo
(86) International application number: JP0106790
(87) International publication number: WO02011996

(57) **Abstract**

The present invention is directed to provide a heat-sensitive recording-type material for a litho printing plate, wherein an image having a high resolution can be reproduced at a high, heat-sensing responsiveness and with no phenomenon, and to provide a litho printing plate, wherein a high-quality printing can be achieved at a high resolution using the heat-sensitive recording-type material, and a process for producing the litho printing plate.

In a heat-sensitive recording-type material for a litho printing plate, a litho printing plate and a process for producing the latter according to the present invention, a carboxylic compound having a functional group comprising a carboxyl group protected by a vinyl ether is used, whereby a hydrophilic surface is converted into a lipophilic and hydrophobic surface or vice verse by applying a heat during production of the plate, thereby eliminating problems associated with the prior art.

## Description

### TECHNICAL FIELD

The present invention relates to a heat-sensitive recording-type material for a litho printing plate, a process for producing a litho printing plate, and a litho printing plate produced by the process.

### BACKGROUND ART

In recent years, a computer-to-plate(CTP) has been coming into wide use, wherein image data are drawn directly on a printing plate material in the course of fabrication of a litho printing plate for the purpose of providing a film-less type, stabilizing the quality and shortening the procedure and the appointed time of delivery.

Materials for the CTP plate include those of a type having an image formed on a hydrophilic support in an ink jet process or an electronic photographic process, a photo-polymer type having a heat-sensitive layer provided on a support and treated ty a developing solution after an image exposure, a silver salt photographic type and the like.

In the ink jet process and the electronic photographic process, however, the resolution is insufficient. In the photo-polymer type and the silver salt photographic type, a developing treatment is carried out using the developing solution and for this reason, there are problems in respect of the discarding of the developing solution and the working environments in a placing area.

Therefore, among the CTP plate materials, a thermal-type CTP plate material, which is capable of realizing a high resolution without need for a developing solution and in which an image can be drawn by a laser beam, is required.

Various thermal-type CTP plate materials have been proposed conventionally. The principle of these materials is in that a hydrophilic resin is converted into a lipophilic and hydrophobic surface by a heat.

For example, a litho printing plate material has been proposed, in Japanese Patent Application Laid-open No.62-164049, which includes a layer having a hydrophilic surface provided on a support, and a resin contained on the layer and having a blocked isocyanate and a functional group capable of reacting with the isocyanate.

In this prior art material, the blocking of the blocked isocyanate is released to produce isocyanate, which acts as a curing agent and reacts with the resin to provide a lipophilic surface.

Many other litho printing plate materials using a blocked isocyanate as a thermally curing agent have been proposed. However, these materials suffer from the following problems: When the blocked isocyanate is used, if it is premised on an assumption that a litho printing plate material is produced in a coating process, it is necessary to select a blocked isocyanate having a block-dissociating temperature equal to or higher than 100°C. Thus, the heat capacity for the block dissociation is larger; it is necessary to set the temperature of a heat to be applied during production of a litho printing plate at a higher level; and a longer drawing time is required. There are further problems that the larger heat capacity for the block dissociation causes a disturbance of an image to appear due to a diffusion of heat, and thus, it is impossible to realize an image having a high resolution.

Therefore, to the thermal-type CTP plate material, a performance capable of increasing the heat-sensing responsiveness and reproducing an image having a high resolution is demanded, and a further improvement is desired.

### DISCLOSURE OF THE INVENTION

The present invention has been accomplished with the forgoing points in view, and it is an object of the present invention to provide a heat-sensitive recording-type material for a litho printing plate, wherein an image having a high resolution can be reproduced at a high heat-sensing responsiveness and with no phenomenon, and to provide a litho printing plate, wherein a high-quality printing can be achieved at a high resolution using the heat-sensitive recording-type material, and a process for producing the litho printing plate.

To achieve the above object, the present inventors have made zealous studies and found that the hydrophilic surface can be converted into a lipophilic and hydrophobic surface and vice versa by application of a heat at the time of production of the plate, thereby eliminating the above-described problems. Thus, the present invention has been accomplished.

More specifically, a heat-sensitive recording-type material for a litho printing plate according to a first aspect of the present invention has a feature that a heat-sensitive recording layer having a hydrophilic resin, on epoxy group-containing compound and a carboxylic compound with a carboxyl group protected by a vinyl ether as a thermally curing agent is provided on a support.

The material is formed in the above manner and hence, the carboxylic compound included in the heat-sensitive recording layer and having the carboxyl group protected by the vinyl ether, when it is heated, has the carboxyl group regenerated substantially quantitatively. The carboxyl group starts an esterifying reaction with the epoxy group, namely, a curing reaction, thereby converting the hydrophilic surface of the heat-sensitive recording layer into a hydrophobic surface. Therefore, it is possible to form a litho printing plate having an imaged area as a hydrophobic surface and a non-imaged area as a hydrophilic surface by applying a heat energy to the heat-sensitive recording layer in correspondence to an image.

The heat-sensitive recording-type material for a litho printing plate according to the first aspect of the present invention also has a feature that a light-heat converting agent is contained in or outside the heat-sensitive recording layer.

By containing the light-heat converting agent in the heat-sensitive recording layer as described above, a heat can be applied by application of light, and the energy of light can be converted into a heat energy by matching the wavelength of light from a light source with the wavelength of absorbed light the light-heat converting agent.

A heat-sensitive recording-type material for a litho printing plate according to a second aspect of the present invention has a feature that a heat-sensitive recording layer containing a polymer of an unsaturated carboxylic acid having a functional group comprising a carboxyl group protected by a vinyl ether is provided on a support.

The polymer of the unsaturated carboxylic acid having the functional group comprising the carboxyl group protected by a vinyl ether, which is contained in the thus formed heat-sensitive recording layer, has the carboxylic group regenerated substantially quantitatively by application of a heat, thereby converting the hydrophobic surface of the heat-sensitive recording layer into a hydrophilic surface. Therefore, it is possible to form a litho printing plate having an imaged area as a hydrophobic surface and a non-imaged area as a hydrophilic surface by applying a heat energy to the heat-sensitive recording layer in correspondence to an image.

The heat-sensitive recording-type material for a litho printing plate according to the second aspect of the present invention also has a feature that the surface of the heat-sensitive recording layer before being subjected to the printing is treated by an aqueous solution of alkali having a pH value of 8 to 12.

The hydrophilic nature of the carboxyl group regenerated by the application of the heat can be realized reliably by the surface treatment. This is effective, particularly, for preventing the printing smudge from being produced on the non-imaged area from the start of the printing.

The heat-sensitive recording-type material for a litho printing plate according to the second aspect of the present invention has a further feature that a light-heat converting agent is contained in or outside the heat-sensitive recording layer.

By containing the light-heat converting agent in the heat-sensitive recording layer as described above, a heat can be applied by application of light, and the energy of light can be converted into a heat energy by matching the wavelength of light from a light source with the wavelength of absorbed light the light-heat converting agent.

A process for producing a litho printing plate according to the present invention comprises the step of applying light to a heat-sensitive recording-type litho printing plate material according to the present invention for a positive image or a negative image to heat a light-heat converting agent, thereby recording an image on the heat-sensitive recording layer to produce a litho printing plate.

For example, a laser is used as a light source, and a highly fine image can be recorded on the heat-sensitive recording layer by constricting a laser beam from the laser to reduce the spot diameter.

A process for producing a litho printing plate according to the present invention comprises the steps of adding a thermally discolorable color matter of pigment in or outside a heat-sensitive recording layer of a heat-sensitive recording-type litho printing plate material to colorize the printing material, and applying a heat to cause an optical variation in concentration and a variation in hue attributable to a thermal discoloration, thereby forming an image to produce a litho printing plate.

In the litho printing plate formed in the above manner, the image recorded on the heat-sensitive recording layer can be visually seen, and the image on the litho printing plate can be recognized prior to the printing.

Further, a litho printing plate according to the present invention has a feature that it is produced according to any of the two types of the litho printing plate-producing processes.

With such feature, it is possible to form a litho printing plate having a highly fine positive image or negative image.

### BEST MODE FOR CARRYING OUT THE INVENTION

The present invention will now be described by way of embodiments.

### First Group of Invention

First, a heat-sensitive recording-type material for a litho printing plate, a process for producing a litho printing plate and a litho printing plate produced by the producing process will be described.

The heat-sensitive recording-type material for the litho printing plate in this group comprises a support, and a heat-sensitive recording layer provided on the support and including a hydrophilic resin, an epoxy group-containing compound, and a carboxylic compound having a carboxylic group protected by a vinyl ether as a thermally curing agent.

In addition, the heat-sensitive recording-type material has a light-heat converting agent in or outside the heat-sensitive recording layer, and further, is colored by a color matter or a pigment capable of being discolored thermally.

### Description of Composition of Heat-sensitive recording layer

Main constituents of the heat-sensitive recoding layer in this group are (1) a hydrophilic resin, (2) an epoxy group-containing compound, and (3) a carboxylic compound having a carboxylic group protected by a vinyl ether as a thermally curing agent.

### (1) Hydrophilic resin

It is required that a hydrophilic resin utilizable in the material formed as described above according to the present invention has a hydrophilic nature ensuring that a smudge is not produced on a non-imaged area upon the printing. A preferred hydrophilic resin is a polymer containing a monomer having a hydrophilic group (such as hydroxyl group, amide group and the like) other than carboxylic group as a functional group , and a co-polymerizable monomer. Examples of a monomer having a functional group are, for example, 2-hydroxyethyl methacrylate, 4-hydroxybutyl acrylate, acrylamide, methylol acrylamide and the like. Examples of a co-polymerizable monomer are methacrylic esters and acrylic esters such as methyl acrylate, ethyl acrylate and the like, styrene, butadiene, acrylamide and the like. Polyvinyl alcohol, gelatin and the like are preferred hydrophilic resins.

The hydrophilic resin used in the present invention enhances the rub resistance of the non-imaged area of the printing plate and hence, can be used in combination with a curing agent. A point to be considered is in that the amount of the epoxy group-containing compound reacting for curing with the carboxylic compound having the carboxyl group protected by the vinyl ether is increased, or a curing agent reacting with a functional group of the hydrophilic resin preferentially more than the epoxy group is selected. Curing agents, which can be used are conventionally known curing agents, except for the point to be considered. Such curing agents include, for example, an amino resin, an aziridine resin, an amino compound, aldehydes, an isocyanate compound, a carboxylic acid or the anhydride thereof, a halogen compound, a phenol formaldehyde resin and the like.

The hydrophilic resin may be contained in an amount in a range of 50 to 97 % by weight, preferably, in a range of 60 to 95 % by weight of a heat-sensitive recording layer after being coated. If the amount of the hydrophilic resin is lower than 50 % by weight, a smudge is produced on the non-imaged area upon the printing. If the amount of the hydrophilic resin is higher than 95 % by weight, the lipophilic and hydrophobic natures of a thermally deposited imaged area are insufficient and hence, the ink-depositability of an imaged area during the printing is lower and as a result, the concentration of a printed image is not increased.

### (2) Epoxy group-containing compound

An epoxy group-containing compound used in the present invention may be an epoxy resin or an epoxy group-containing organic substance, but the epoxy resin is preferred. Examples of the epoxy resin are, resins made by co-polymerizing a monomer such as glycidyl methacrylate, glycidyl acrylate, 3,4-epoxycyclohexanyl metharylate and the like, and various types of bis-phenols A.

Epoxy groups are contained 1 to 10, preferably, 2 to 8 in one molecule of the epoxy group-containing compound, and the epoxy equivalent may be in a range of 50 to 860, preferably, 100 to 800. If the number of epoxy groups is equal to larger than 11 or the epoxy equivalent is smaller than 50, the hydrophilic nature of the heat-sensitive recording layer is lower and hence, a smudge is produced on the non-imaged area upon the printing. If the epoxy equivalent is larger than 800, the number of thermally curing reaction sites is decreased, and the lipophilic nature of the imaged area is insufficient, resulting in a decreased concentration of a printed image.

### (3) Carboxylic compound having carboxyl group protected by vinyl ether as thermally curing agent

The carboxylic compound having the carboxyl group protected by the vinyl ether may be prepared by an addition reaction of a carboxylic acid compound and a vinyl ether.

The carboxylic acid compound may be aromatic or aliphatic and unsaturated and may be a polymer having a molecular weight in a range of 1,000 to 20,000. Typical of such carboxylic acid compound are aliphatic poly-carboxylic acids having 2 to 22 carbon atoms such as succinic acid, adipic acid, azelaic acid, sebacic acid and decamethylene carboxylic acid; aromatic carboxylic acids such as phthalic acid , isophthalic acid, terephthalic acid, trimellitic acid and pyromellitic acid; cycloaliphatic poly-carboxylic acids such as tetrahydrophthalic acid, hexahydrophthalic acid and methylhexahydrophthalic acid; unsaturated carboxylic acids such as acrylic acid, methacrylic acid, maleic acid, fumaric acid, itaconic acid; and a polyester resin, an acrylic resin, a maleate polybutadiene resin, which have one or more carboxyl groups in one molecule.

Typical of the vinyl ether is aliphatic vinyl ether compounds such as methyl vinyl ether, ethyl vinyl ether, isopropyl vinyl ether, n-propyl vinyl ether, n-butyl vinyl ether, isobutyl vinyl ether, 2-ethylhexyl vinyl ether, cylclohexyl vinyl ether, and aliphatic vinyl thio-ether compounds corresponding to the aliphatic vinyl ether compounds; and further, cyclic vinyl ether compounds such as 2,3-dihydrofuran, 3,4- dihydrofuran, 2,3-dihydro-2H-pyran, 3,4-dihydro-methoxy-2H-pyran, 3,4-dihydro-4,4-dimethyl-pyran-2-one, 3,4-dihydro-2-ethoxy-2H-pyran, and cyclicvinyl thio-ether compounds corresponding to the cyclic vinyl ether compounds.

To produce the carboxylic compound having the carboxylic group protected by the vinyl ether, a vinyl ether is added to a carboxylic acid at room temperature to 100° C in the presence of an acidic catalyst to provide a compound having a functional carboxyl group protected by the vinyl ether. It is preferable that the amount of vinyl ether added to the carboxylic acid compound is the same mole or the same mole to 1.2 times the moles of the carboxylic acid compound. If the amount of vinyl ether added is smaller than the same mole, the blocking of the carboxyl group is insufficient. If the amount of vinyl ether added is larger than 1.2 times, the vinyl ether acts as a solvent for a coating during formation of the heat-sensitive recording layer, whereby a coated surface is liable to be impeded, because the vinyl ether has a higher volatility.

To determine a ratio of the amount of the carboxylic compound having the carboxyl group protected by the vinyl ether to the amount of epoxy group-containing compound, it is necessary to adjust the chemical equivalent of the carboxyl group contained and the epoxy equivalent, and the amount of the carboxylic compound having the carboxyl group protected by the vinyl ether may be determined so that the carboxyl group is contained in a chemical equivalent 0.8 to 1.5, preferably, 1.1 to 1.3 times the epoxy equivalent of the epoxy group-containing compound. If the amount of the carboxylic compound is smaller than 0.8 times the epoxy equivalent of the epoxy group-containing compound, the heat-sensitive recording layer is cured insufficiently, resulting in an insufficient lipophilic nature. If the amount of the carboxylic compound is larger than 1.5 times the epoxy equivalent of the epoxy group-containing compound, the unreacted carboxylic acid is present in the form of a hydrophilic functional group after the thermal curing, also resulting in an insufficient lipophilic nature. In addition, the ink depositability of the imaged area during the printing is reduced and thus, the concentration of a printed image is not increased.

The total amount of the carboxylic compound having the carboxyl group protected by the vinyl ether and the epoxy group-containing compound is in a range of 3 to 50 % by weight, preferably, 5 to 30 % by weight of the heat-sensitive recoding layer after being coated. If the total amount of smaller than 3 % by weight, the lipophilic nature cannot be realized by the thermal curing, resulting in a reduced concentration of a printed image provided upon the printing. If the total amount is larger than 50 % by weight, the hydrophilic nature of thermally uncured portion is insufficient and thus, a smudge is produced on the non-imaged area upon the printing.

In the heat-sensitive recoding layer in this group, one or more of (4) a light-heat converting agent, (5) a color matter or a pigment, (6) a filler and (7) a curing accelerator, which will be described hereinafter, may be added in addition to the main constituents. Among the additional constituents, (4) the light-heat converting agent can be provided in or outside the heat-sensitive recording later.

### (4) Light-heat converting agent

When an image is recorded on the litho printing plate by application of light from a laser, a lamp or the like, a light-heat converting agent may be additionally contained in the main constituents for the heat-sensitive recording layer.

The light-heat converting agent may be present anywhere, if heat produced by the light-heat conversion can be transferred to the heat-sensitive recording layer. For example, the light-heat converting agent may be present in a layer other than the heat-sensitive recording layer, or in the support.

The light-heat converting agent is preferably a material capable of absorbing light and efficiently converting the light into heat, and may be changed in accordance with a light source used for the recording of an image. When a near infrared semiconductor laser is used, a material having a light absorption range in a near infrared range is preferred. Typical of the material which may be used are, for example, organic compounds such as carbon black, a cyanine color matter, a polymethine color matter, an azulenium color matter, a squwalium color matter, a thiopyrylium color matter, a naphthoquinone color matter, an anthraquinone color matter and the like, and organic metal complexes such as phthalocyanine, azo, thioazo color matters, and the like.

One type of the light-heat converting agent may be used alone, or two or more types of the light-heat converting agents may be used in combination with on another.

A deposited film may be used as the light-heat converting agent. Examples of the deposited film are a deposited film of carbon black, and deposited films of metal black such as gold, silver, aluminum, chronium, nickel, antimony, tellurium, selenium and the like.

When the light-heat converting agent is provided in a layer other than the heat-sensitive recording layer, it is preferable that the light-heat converting agent is present in a layer containing a binder added therein. A resin having a higher Tg and a higher heat transfer coefficient is used as the binder. For example, a common heat-resistant resin such as polymethyl methacrylate, polystyrene, polyvinyl alcohol, polycarbonate, ethyl cellulose and the like can be used.

A water-soluble polymer may be also used as the binder. When the water-soluble polymer is used, it is preferable that a light-heat converting substance is rendered water-soluble by introduction of a functional group such as sulfone group, or is dispersed in water.

When the light-heat converting agent is provided in the layer other than the heat-sensitive recording layer, as described above, the thickness of the heat-sensitive recording layer is preferably in a range af 0.1 to 5 µm, more preferably in a range of 0.5 to 3 µm. If the thickness is smaller than 0.1 µm, the generation of heat is insufficient. If the thickness is larger than 5 µm, the temperature is not raised due to the diffusion of heat.

The content of the light-heat converting agent is adjusted, so that the absorbency at a wavelength of a light source used for formation of an image is in a range of 0.5 to 4.0, preferably 1.0 to 3.0. If the absorbency is smaller than 0.5 or larger than 4.0, an increase or decrease in thickness of an image is generated upon recording of the image.

### (5) Color matter or pigment

When the plate material including the thermally discolorable color matter or pigment contained in or outside the heat-sensitive recording layer according to the present invention is colored and an image is recorded on the heat-sensitive recording layer by the application of heat, the image can be formed simultaneously by the thermal discoloration of the color matter or pigment.

The color matters or pigments, which may be used, for example, are organic compounds such as a cyanine color matter, a polymethine color matter, an azulenium color matter, a squwalium color matter, a thiopyrylium color matter, a naphthoquinone color matter, an anthraquinone color matter and the like, and organic metal complexes such as phthalocyanine, azo, thioazo color matters, and the like. Further, a color matter and a colorant for a heat-sensitive paper may be used in combination.

Even a color matter or pigment as used in the light-heat converting agent may be also used if they are thermally discolored, and some of the above-described color matters or pigments may be used in combination.

In the use of the color matter or pigment capable of being thermally discolored, the color matter or pigment may be added to the heat-sensitive recording layer to colorize the color matter or pigment itself, or may be incorporated in a layer other than the heat-sensitive recording layer or in the support.

The amount of color matter or pigment added should be determined in accordance with the type thereof, the type of a coating solvent, the degree of coloration of the heat-sensitive recording layer and the degree of thermal discoloration.

### (6) Filler

Any of various types of fine particles may be added as a filler to the heat-sensitive recording layer in the present invention.

Examples of organic fine particles are fine particles of radical-polymerized polymers such as polymethyl methacrylate, polystyrene, polyethylene, polypropylene and the like, and fine particles of polycondensated polymers such as polyester, polycarbonate and the like.

Examples of in organic fine particles are fine particles of zinc oxide, titanium oxide, barium sulfate, calcium carbonate, silica and the like. Inorganic ultra fine particles may be also used. For example, they include inorganic ultra fine particles colloidal silica, alumina sol colloidal alumina, cationic aluminum oxide or hydrate.

The particle size of the filler. which may be used, is in a range of 0.05 to 20 µm, and the amount of filler added is determined properly as requited.

One type of the fillers may be used alone, or two or more types of the fillers may be used in combination with one another.

### (7) Curing accelerator

In this group of the present invention, a curing catalyst may be also used. It is desirable that, if possible, a curing catalyst exhibiting an activity at a temperature of 60°C or higher is used. If a curing catalyst exhibiting an activity at a temperature lower than 60°C is used, there is a possibility that undesirable situations are arisen, and for example, a coating and/or a coated article is thickened or gelatinized, and a coating film is deteriorated.

Examples of the curing catalyst are a compound made by neutralizing a protonic acid with a Lewis base, a compound made by neutralizing a Lewis acid with a Lewis base, a mixture of a Lewis acid and trialkylphosphate, sulfonates, phosphates, an onium compound and the like.

The heat-sensitive recording layer in this group is formed on the support by applying a mixture of the main constituents comprising (1) the hydrophilic resin, (2) the epoxy group-containing compound and (3) the carboxylic compound having the carboxyl group protected by the vinyl ether and serving as the thermally curing agent, and/or one or more of the additional constituents (4) to (6) to the support.

The thickness of the heat-sensitive recording layer is preferably in a range of 1 to 30 µm, more preferably in a range of 3 to 20 µm. If the thickness is smaller than 1 µm, the hydrophilic nature during the printing is insufficient, and a smudge is liable to be produced on the non-imaged area. If the thickness is larger than 30 µm, the heat capacity required for the heating is increased, and the image reproducibility of a high resolution is decreased.

### Description of Support

Any of conventionally known supports can be used particularly unlimitedly as the support used in the present embodiment. The material, the layer structure and the size of the support may be selected properly in accordance with the purpose of use and the like.

Examples of the support are various papers such as a paper, a coated paper, a synthetic paper (a composite material comprising a paper and any of various films or the like adhered thereto) and the like, various single-layer or laminated-layer plastic films or sheets such as a polyethylene terephthalate film, a polyvinyl chloride sheet, polyethylene film, a polypropylene film and the like, metal plates such as aluminum, a stainless steel, chromium, nickel and the like, various thin laminates of metals, resin-coated papers, plastics films and sheets and the like.

It is preferable that a resin-coating layer is provided as an undercoat layer en a surface of the support by an acid treatment, a corona treatment or a plasma treatment in order to ensure and enhance the wetness during coating of the heat-sensitive layer and the adhesion of the heat-sensitive layer to the support.

A process for producing a heat-sensitive recording-type material for a litho printing plate will be described below.

Constituents for a heat-sensitive recording layer are prepared in accordance with the amounts described in the item "Description of Composition of Heat-sensitive recording layer" in this group and dispersed and mixed fully along with a solvent which will be described hereinafter by a paint shaker, a ball mill, a ultrasonic homogenizer, a agitator or the like. The resulting coating liquid is applied onto the support by a known coating process, e.g., a doctor blade process, a bar coating process, a roll coating process, a gravure coating process or the like and then dried to produce a heat-sensitive recording-type material for a litho printing plate according to the present invention.

Examples of a solvent, which can be used in the application or the coating liquid, are ketones such as acetone, methyl ethyl ketone and the like, aromatic hydrocarbons such as toluene, xylene and the like, esters such as ethyl acetate, butyl acetate, and the like, ethylene glycol, propylene glycol monomethyl ether acetate, ethyl cellosolve and the like. One of these substances may be used alone, or two or more of these substances may be used in the form of a mixture.

A process for producing a litho printing plate by forming an image on the heat-sensitive recording-type material formed for the litho printing plate in the above-described manner will be described below.

A process for recoding an image on the heat-sensitive recording-type material for the litho printing plate according to the present invention, which may be used, includes a process comprising the step of applying a heat energy directly to the material by a thermal head or the like, a process comprising the step of applying a high-output light energy and converting it into a heat energy, and the like.

A light source, which may be used for exposure of an image, includes, for example, a laser, a light-emitting diode, a xenone electronic-flush lamp, a halogen lamp, a carbon arc lamp, a metal halide lamp, a tungsten lamp and the like.

An exposing process comprises a step of superposing a mask having a desired image pattern formed by a light-shielding material onto the litho printing plate, and a step of exposing them collectively using any one of various lamps.

An exposure of a digital type corresponding to an image signal can be used by using an array-type light source such as a light-emitting diode array, an optical shutter such as a liquid crystal and the like, whereby the direct writing can be carried out without use of a mask material and the like.

Further, if a laser is used as a light source, light can be constricted into a beam shape to reduce the exposure area into a very small size, thereby conducting an image recording of a high resolution. Laser light sources, which may be used, are argon laser, an He-Ne gas laser, a YAG laser, a semiconductor laser and the like.

The formation of an image in the above-described manner will be described along with the function of the heat-sensitive recording-type material for the litho printing plate according to the embodiment in the first group of the present invention.

In the present embodiment, an image is exposed using a semiconductor laser, e.g., an infrared ray laser having a wavelength of 830 nm and an output of 500 nw and recorded on the heat-sensitive recording-type material for the litho printing plate.

At that time, the carboxylic compound having the carboxyl group protected by the vinyl ether and included in the heat-sensitive recording-type material in the present embodiment, when it is heated to 120° C, regenerates the carboxyl group substantially quantitatively. After regeneration of the carboxyl group, this compound starts an esterifying reaction with the epoxy group, namely, a curing reaction to convert the hydrophilic surface of the heat-sensitive recording-type material into a hydrophobic surface. Therefore, the image comprising hydrophobic surface portions can be formed by applying the heat energy to the heat-sensitive recording layer in correspondence to the image, thereby forming the litho printing plate. The vinyl ether thermally dissociated is added to a product resulting from the esterifying reaction and chemically retained within the heat-sensitive recording layer. Therefore, this process cannot pollute the surrounding environments in the producing course and hence, is soft to the environments.

Further, the carboxylic compound having the carboxylic group protected by the vinyl ether has a small heat capacity for thermal disassociation and exhibits a fast curing reaction, as compared with blocked isocyanate in the prior art.

In the recording of the image achieved in the above manner, the imaged area and the non-imaged area are distinguished distinctly from each other, and the litho printing plate having a high resolution is fabricated. Particularly, if a heat energy is applied using a high-output infrared laser beam to record an image, a highly fine image can be formed by the laser beam.

In addition, the energy applied by the laser beam can be converted efficiently into a heat energy by provision of the light-heat converting agent in or outside the heat-sensitive recording layer in this group, thereby recording a highly fine image extremely efficiently.

An optical variation in concentration due to the thermal discoloration can be produced in a heat-applied area of the heat-sensitive recording layer by adding the thermally discolorable color matter or pigment to the heat-sensitive recording layer in this group, thereby forming a highly fine image which can be visually recognized

If the printing is carried out using the heat-sensitive litho printing plate having the image formed thereon in the above manner in the present invention, the non-imaged area is not smudged at all and moreover, a high-grade print can be achieved at a high resolution.

In addition, it is preferable that the heat-sensitive recording layer or an opposite surface of the litho printing plate acoording to the present invention is roughened.

Any of various roughening processes can be used, if it cannot exert physical and chemical adverse influences to the surface of the litho printing plate. For example, such processes include a process for forming a rugged pattern by a resin layer containing a matting agent or a coating layer, and mechanically and physically roughening processes.

Solid particles similar to those used in the heat-sensitive recoraing layer can be used as the matting agent in the matting agent-containing resin layer. The particle size of the matting agent particles is preferably in a range of 0.1 to 20 µm, more preferably in a range of 0.5 to 5 µm. If the particle size is smaller than 0.1 µm, a roughening effect is not achieved. If the particle size is larger than 20 µm, the heat-sensitive recording layer on the surface is damaged.

The thickness of the roughened layer is preferably in a range of 2 to 30 µm. If the thickness is smaller than 2 µm or larger than 30 µm, it is difficult to provide a desired roughness.

### Second of the invention

A heat-sensitive recording-type material for a litho printing plate, a process for producing a litho printing plate and a litho printing plate produced by this process, which are embodiments in a second group of the present invention, will be described below.

A heat-sensitive recording-type material for a litho printing plate in the second group includes a support, and a heat-sensitive recording layer provided on the support and containing a polymer of an unsaturated carboxylic acid having a functional group comprising carboxyl group protected by a vinyl ether.

In addition, the material includes a light-heat converting agent in or outside the heat-sensitive recording layer, and is colored by a color matter or a pigment used in the light-heat converting agent.

### Description of Composition of Heat- sensitive recording layer

A main constituent for the sensitive recording layer in the second group is (1) a polymer of an unsaturated carboxylic acid having a functional group comprising a carboxyl group protected by a vinyl ether.

### Polymer of unsaturated carboxylic acid having functional group comprising carboxyl group protected by vinyl ether

A polymer of an unsaturated carboxylic acid having a functional group comprising carboxyl group protected by a vinyl ether, which can be utilized in the present invention, can be produced, for example, by any of the following processes (a) and (b):
(a) A carboxyl group-containing α,β-unsaturated monomer is homopolymerized or copolymerized with another copolymerizable monomer to provide a polycarboxyl compound and then, a carboxyl group of the polycarboxyl compound is protected using any one of the above-described vinyl ethers. Examples of the carboxyl group-containing α,β-unsaturated monomer are acrylic acid, methacrylic acid, itaconic acid, mesaconic add, maleic acid, fumaric acid and the like.
   Examples of the other α,β-unsaturated monomer copolymerized with the carboxyl group-containing α,β-unsaturated monomer are methyl (meth)acrylate, ethyl (meth)acrylate, n-propyl (meth)acrylate, isopropyl (meth)acrylate, n-butyl (meth)acrylate, sec-butyl (meth)acrylate, t-butyl (meth)acrylate, cyclohexyl (meth)acrylate, 2-ethylhexyl (meth)acrylate, lauryl (meth)acrylate, stearyl (meth)acrylate, styrene, α-methyl styrene, p-vinyl toluene, acrylonitrile, polyethylene glycol (meth)acrylate, polypropylene glycol mono(meth)acrylate, monomethyl ether polyethylene glycol mono(meth)acrylate, monoethyl ether polyethylene glycol mono(meth)acrylate, monomethyl ether polypropylene glycol mono(meth)acrylate, monoethyl ether polypropylene glycol mono(meth)acrylate, and the like.
   Any one of the above-described vinyl ethers is added to the polycarboxyl group-containing compound produced in the above manner at a room temperature to a temperature of 100° C in the presence of an acidic catalyst to protect the carboxyl group of the polycarboxyl group-containing compound by the vinyl ether.
(b) The carboxyl group of the carboxyl group-containing α,β-unsaturated monomer is previously protected using any of the above-described vinyl ethers, then, the carboxyl group-containing unsaturated monomer having a functional group comprising the carboxyl group protected by the vinyl ether is homopolymerized or copolymerized with another copolymerizable monomer to provide a carboxyl compound having a protected group.

Examples of such carboxyl group-containing α,β-unsaturated monomer and the other α,β-unsaturated monomer copolymerized with the carboxy group-containing α,β-unsaturated monomer include those described above.

The process (b) is preferable than the process (a) from a point of the reactivity or the like.

The molecular weight of this polymer may be in a range of 3,000 to 100,000, preferably in a range of 5,000 to 50,000. If the molecular weight is too small, the polymer is dissolved during printing, resulting in an insufficient rub resistance. If the molecular weight is too large, the hydrophilic nature is reduced and as a result, a printing smudge is generated.

The heat-sensitive recording layer in this group may be formed by a single constituent comprising the polymer of the unsaturated carboxylic acid having the functional group comprising the carboxyl group protected by the vinyl ether. Alternatively, any of a hydrophilic resin, a lipophilic resin, an epoxy resin and the like may be also used in the form of a mixture with such constituent to form the heat-sensitive recording layer.

The hydrophilic resin used in the form of the mixture with such constituent is particularly not limited, and any of the conventionally known hydrophilic resins may be used. For example, a polymer containing a monomer having a hydrophilic functional group (e.g., carboxyl group, hydroxyl group, amide group and the like) and a copolymerizable monomer is preferred. Typical of the monomer having the functional group are 2-hydroxyethyl methacrylate, 4- hydroxybutyl acrylate, acrylamide, methylol acrylamide and the like. Typical of the copolymerizable monomer are methyl acrylate, ethyl acrylate, styrene, butadiene and the like. Any of Polyvinyl alcohol, gelatin and the like is also a preferable hydrophilic resin.

The hydrophilic resin can be mixed in an amount which dose not impede the hydrophobic nature of the surface of the heat-sensitive recording layer, and the amount of hydrophilic resin mixed is equal to or smaller than 50 % by weight, preferably equal to or smaller than 40 % by weight of the heat-sensitive recording layer after being coated. If the amount hydrophilic resin mixed exceeds 50 % by weight, the hydrophobic nature of the surface of the heat-sensitive recording layer is reduced and a result, the ink-depositability of the imaged area during printing is reduced and the image concentration is not increased.

The hydrophilic resin used in combination with the above-described constituent is used to enhance the hydrophobic nature and the lipophilic nature of the surface of the heat-sensitive recording layer as required.

The hydrophilic resin is particularly not limited, and any of the conventionally known hydrophilic resins can be used. For example, such hydrophilic resins include an acrylic resin such as a copolymer produced from an acrylic acid ester and a methacrylic acid ester as main components, waxes such as natural wax and a polyethylene wax, a synthetic rubber such as a styrene-butadiene copolymer, methacryic acid ester-butadiene copolymer and the like.

The amount of hydrophilic resin mixed is not defined by % by weight, and is required to be determined by the degrees of the lipophilic nature and the hydrophobic nature of the polymer of the unsaturated carboxylic acid having the functional group comprising the carboxyl group protected by the vinyl ether according to the present invention.

The amount of hydrophilic resin mixed may be increased and decreased, as required, in accordance with the degrees of the lipophilic nature and the hydrophobic nature of the surface of the heat-sensitive recording layer and the hydrophilic nature of the heat-sensitive recording layer after application of heat.

The epoxy resin and the epoxy group-containing compound may be used, if there are problems in the film-forming property of the heat-sensitive recording layer and the adhesion of the heat-sensitive recording layer with the support. Examples of the epoxy resin and the epoxy group-containing compound are resins resulting from copolymerization of monomers such as glycidyl methacrylate, glycidyl acrylate, 3,4-epoxycyclohexane and the like, and various bisphenols A.

The amount of epoxy resin and the like mixed depends on the film performance of the polymer of the unsaturated carboxylic acid having the functional group comprising the carboxyl group protected by the vinyl ether and the characteristic of the surface of the support, and is equal to or smaller than 10 % by weight of the heat-sensitive recording layer. If the amount exceeds 10 % by weight, a curding reaction. of the epoxy resin with the carboxyl group regenerated upon the application of heat occurs and as a result, the hydrophilic nature of the surface of the heat-sensitive recording layer is insufficient, and a smudge is generated on the non-imaged area during printing.

For the heat-sensitive recording layer in the second group, one or more of additional constituents similar to those in the first group: (4) a light-heat converting agent, (5) a filler and (6) a curding accelerator may be used in addition to the main constituents. Among the additional constituents, (4) the light-heat converting agent can be provided in or outside the heat-sensitive recording layer.

A support similar to that in the first group can be used in the second group.

Further, even in the second group, tbe heat-sensitive recoding layer can be formed on the support to produce a heat-sensitive recording-type material for a litho printing plate, as in the first group.

The following is the description of a process for fabricating a litho printing plate by recoding an image on the heat-sensitive recording-type material formed in the above manner in the second group.

Even in the second group, a heat-sensitive recording-type material for a litho printing plate is produced as in the first group.

More specifically, constituents for the heat-sensitive recording layer are prepared in amounts in correspondence to the amounts described in the item "Description of Composition of Heat-sensitive recording layer in Second group" and are dispersed and mixed fully along with the same solvent as in the first group. The resulting coating liquid is applied onto the support by a known coating process, e.g., a doctor blade process, a bar coating process, a roll coating process, a gravure coating process or the like and then dried to produce a heat-sensitive recording-type material for a litho printing plate according to the present invention.

A process for fabricating a litho printing by recording an image on the heat-sensitive recording-type litho printing plate material formed in the above manner will be described below.

In the second group, a heat energy is applied to the non-imaged area of the heat-sensitive recording-type litho printing plate material to record a negative image.

In this case, the polymer of the unsaturated carboxylic acid having the functional group comprising the carboxyl group protected by the vinyl ether and present in the heat-sensitive recording layer of the heat-sensitive recording-type litho printing plate material is hydrophobic before the application of heat, but when it is heated to 120° C, the carboxyl group is regenerated substantially quantitatively. The carboxyl group is regenerated in the polymer to convert the hydrophobic surface of the heat-sensitive recording layer into a hydrophilic surface. Therefore, a litho printing plate can be fabricated by applying the heat energy to the heat-sensitive recording layer in correspondence to the non-imaged area. The thermally dissociated vinyl ether is added to a product resulting from the esterifying reaction and chemically retained within the heat-sensitive recording layer and hence, this process cannot pollute the surrounding environments in the course of production of the plate and is soft to the environments.

Further, the polymer of the unsaturated carboxylic acid having the functional group comprising the carboxyl group protected by the vinyl ether has a small heat capacity for the thermal disassociation and exhibits a fast thermally decomposing reaction, as compared with the blocked isocyanate used in the prior art.

The steps until the formation of the image is carried out by a procedure similar to that in the first group.

In the second group, the heat-sensitive recording plate before subjected to the printing is subjected to a surface treatment using an aqueous solution of alkali having a pH value of 8 to 12 after recording of the image on the heat-sensitive recording-type litho panting plate material, thereby fabricating a litho printing plate.

The surface treatment using the aqueous solution of alkali is to completely reveal the hydrophilic nature of the heat-applied area after production of the plate to prevent the smudging of the non-imaged area from immediately after the printing. It is preferable that the surface treatment is carried out in a printing procedure, particularly, immediately before the printing, rather than in the plate-producing process.

A material for producing the aqueous solution of alkali is not limited, and examples thereof are hydroxides and carbonates of alkali metal elements and alkali earth metal. elements. Particular examples of them are potassium hydroxide, sodium hydroxide, sodium carbonate, potassium carbonate and the like.

To produce the aqueous solution, the material is dissolved in a predetermined amount in water, so that a pH value in a range of 8 to 12, preferably in a range of 8.5 to 11 is provided. If the pH value is lower than 8, no surface treatment affect is provided. If the pH value is higher than 13, the polymer of the unsaturated carboxylic acid having the carboxyl group regenerated is dissolved.

The surface treatment exhibits a sufficient effect by wetting the surface of the heat-sensitive recording layer using gauze impregnated with the aqueous solution of alkali, but it is preferable that the litho printing plate is rubbed lightly when a highly fine printing image is printed. Further, it is preferable that the surplus aqueous solution of alkali is removed by applying a uniform pressing force by a roller. This is because the surplus aqueous solution of alkali causes an unevenness of concentration during printing.

The polymer of the unsaturated carboxylic acid having the functional group comprising the carboxyl group protected by the vinyl ether is hydrophobic before the application of heat, but has the carboxyl group regenerated substantially quantitatively at 120° C or higher, as in the first group. If the surface treatment using the aqueous solution of alkali is carried out after the regeneration of the carboxyl group, the hydrophobic surface is converted into a hydrophilic surface.

In this way, the second group has the following feature: The heat-applied area is the non-imaged area; the heat-sensitive recording-type material is different from the material in the first group and the thermal-type CTP material conventionally proposed, and the negative image is irradiated in the plate-producing course using the application of light.

When the image is formed in the above manner in the second group, the imaged area and the non-imaged area are distinguished distinctly from each other, and the litho printing plate having a high resolution is fabricated. Particularly, if a high-output infrared laser is used as a light source, and a laser beam from the light source is constricted to form an image at a decreased spot diameter, a highly fine image can be recorded.

In addition, the energy applied by the laser beam can be converted into the heat energy efficiently by providing the light-heat converting agent in or outside the heat-sensitive recording layer in the second group, thereby recording a highly fine image extremely efficiently.

By adding the thermally discolorable color matter or pigment to the plate material in the second group, an optical variation in concentration attributable to a thermal discoloration is generated by the application of heat, and a highly fine image capable of being visually recognized can be formed.

When the printing is carried out using the heat-sensitive litho printing plate having the image formed in the above manner in the present embodiment, the non-imaged area is not smudged at all and moreover, a high-grade print can be achieved at a high resolution.

Examples of the present invention will be described below.

### (Example 1)

### Synthesis of compound A

54 Grams of vinyl isopropyl ether, 72 grams of acrylic acid and 100 grams of methyl ethyl ketone were mixed together, and the resulting mixture was heated to 60°C and agitated for 2 hours to provide a solution of a compound A containing 50 % of solids.

### (Coating material 1)

| | |
|---|---|
| The solution of the compound A | 10 parts by weight |
| Hydrophilic resin L-20 (containing 25 % of solids) made by Soken Chemicals & Engineering Co. Ltd. | 40 parts by weight |
| Epoxy resin EPICLON857 made by Dainippon Ink & Chemicals, Inc. | 5 parts by weight |
| Infrared ray absorbing dye CY-17 (a 10 % by weight solution in methanol) made by Nippon Kayaku, Co. | 10 parts by weight |
| Methyl ethyl ketone | 70 parts by weight |

The above constituents were mixed and agitated together and further kneaded and dispersed for 2 hours in a ball mill pot to provide a coating material 1.

The coating material 1 was applied onto a polyethylene terephthalate (FET) film at a dry thickness of 4.0 µm and dried at 100°C for 3 minutes to produce a litho printing plate material sample 1.

### <Fabrication of litho printing plate>

The litho printing plate material sample 1 was subjected to an exposure of image using a semiconductor laser (wavelength: 830 nm and output: 500 nw) to form a positive image, thereby fabricating a litho printing plate.

Conditions for the exposure of image are as follow: An exposure energy is 200 mj/cm², and a diameter of a laser beam is 20 µ m at a strength of 1/e² at a peak.

After of the exposure of image, a non-exposed area remained dark green and blue, and only an exposed area was thermally discolored and had a white negative image formed thereon. An output image could be recognized easily.

### <Estimation of printing>

The litho painting plate fabricated was mounted on an offset printing machine (2800CD made by Ryobi Imagix, Co.), and subjected to the printing on a high-quality paper using wetting water (containing EU-3 made by Fuji Photographic Film, Co. and diluted 100 times) and an ink (F Gross made by Dainippon Ink & Chemicals, Inc.). As a result, the dark green and blue non-imaged area was not smudged, and 10,000 prints could be obtained.

### (Example 2)

Colloidal silica, Snowtex S (made by Nissan Chemical Industries, Co.) was added in an amount of 10 % by weight to the coating material produced in Example 1 to provide a coating material 2, and a litho printing plate sample 2 was produced in the same manner as in Example 1. The fabrication of a litho printing plate and the estimation of printing were carried out, thereby providing the same result as in Example 1.

### (Example 3)

### Synthesis of compound B

| | |
|---|---|
| Vinyl isopropyl ether | 54 parts by weight |
| Methacrylic acid copolymer (a copolymer having a rate of methyl methacrylate to methacrylic acid equal to 1:1 and a molecular weight of 15,000 and comprising 100 % of solids) | 50 parts by weight |
| Methyl ethyl ketone | 100 parts by weight |

They were heated to 60° C and agitated for 4 hours to provide a solution of a compound B containing 50 % of solids.

### (Coating material 3)

| | |
|---|---|
| Solution of compound B | 20 parts by weight |
| Hydrophilic resin L-20 (containing 25 % of solids) made by Soken Chemicals & Engineering Co. Ltd. | 40 parts by weight |
| Infrared ray absorbing dye CY-17 (a 10 % by weight solution in methanol) made by Nippon Kayaku, Co. | 10 parts by weight |
| Methyl ethyl ketone | 70 parts by weight |

The above constituents were mixed and agitated together and further kneaded and dispersed for 2 hours in a ball mill post to provide a coating material 3.

A litho printing plate sample 3 was produced in the same manner as in Example 1, and the fabrication of a litho printing plate and the estimation of printing were carried out. However, the exposure was carried out for a negative image; a positive image was formed, wherein a non-exposed area was a dark green and blue imaged area and an exposed area was a discolored orange non-imaged area, and an output image was easily recognized.

As a result of the estimation of the printing, the non-imaged area was not smudged, and 10,000 prints were obtained. The litho printing plate was subjected to a pretreatment using an aqueous solution of sodium hydroxide before being subjected to the printing, and was then subjected to a printing test. As a result, the imaged area was not smudged from the start of the printing, and 10,000 prints were obtained.

### (Example 4)

### Synthesis of compound C

57.7 Parts by weight of toluene was charged into a flask having an agitator and heated to 80° C, and a liquid mixture comprising 18.2 parts by weight of 1-iso-propoxyethyl methacrylate (a block compound of iso-propyl vinyl ether of methacrylic acid), 17.0 parts by weight of methyl methacrylate, 0.8 parts by weight of 2-hydroxyethyl methacrylate, 4.0 parts by weight of Blenmer PME 100 (a trade name of methoxypolyethylene glycol monomethacrylate made by NOF Corporation) and 0.3 parts by weight of azo-iso-butyl nitrile (AIEN) as a polymerizing catalyst was dropped into the flak over 3 hours, while conducting the agitation. After completion of the dropping, the mixture was maintained at the same temperature for 3 hours. Then, 2.0 parts by weight of toluene was added to dilute the mixture, thereby providing a solution of 40 % of a copolymer having a functional group comprising a carboxyl group protected by the vinyl either in toluene.

The produced copolymer had a molecular weight of 38,000.

### (Coating material 4)

| | |
|---|---|
| Solution of compound B Infrared ray absorbing dye YKR-3079 (a 0.002 % by weight solution in methyl ethyl ketone) made by Yamamoto Chemicals Inc. | 25 parts by weight |
| | 5 parts by weight |
| Methyl ethyl ketone | 20 parts by weight |

The above constituents were mixed and agitated together to provide a coating material 4.

A litho printing plate sample was produced in the same manner as in Example 3, and the fabrication of a litho printing plate and the estimation of printing were carried cut. As a result, a positive image was formed, wherein a non-exposed area was a dark green and blue imaged area and an exposed area was a discolored orange non-imaged area, and an output image was easily recognized.

The litho printing plate was subjected to a pretreatment using an aqueous solution of sodium hydroxide having a pH value of 10 as in Example 3 and was then subjected to a printing test. As a result of the estimation of the printing, the imaged area was not smudged from the start of the printing, and 10,000 prints were obtained.

### (Comparative Example 1)

A coating material 5 which will be described below was applied onto a polyethylene terephthalate (PET) film at a dry thickness of 4.0 µm and dried at 100°C for 3 minutes, thereby producing a litho printing plate sample 4.

### (Coating material 5)

| | |
|---|---|
| Hydrophilic resin L-20 (containing 25 % of solids) made by Soken Chemicals & Engineering Co. Ltd. | 40 parts ty weight |
| Blocked isocyanate, Coronate 2513 made by Nippon Polyurethane Industry, Co. | 5 parts by weight |
| Infrared ray absorbing dye CY-17 (a 10 % by weight solution in methanol) made by Nippon Kayaku, Co. | 10 parts by weight |
| Methyl ethyl ketone | 70 parts by weight |

The above constituents were mixed and agitated together to provide a coating material 5.

The fabrication of a litho printing plate and estimation of printing were carried out in the same manner as in Example 1. If an image was confirmed after an exposure, the image was indistinct, as compared with those in the examples of the present invention. When the litho printing plate was used to carry out the printing, a good printed image was not obtained, and a slight smudge was generated on the non-imaged area. In addition, only about 5,000 prints were obtained.

### (Comparative Example 2)

A coating material 6 which will be described below was applied to a polyethylene terephthalate (PET) film at a dry thickness of 4.0 µm and dried at 100° C for 3 minutes, thereby producing a litho printing plate sample 5. The produced sample was subjected to an aging treatment at 40° C for 3 days, whereby the hydrophilic resin was cured.

### (Coating material 6)

| | |
|---|---|
| Hydrophilic resin, polyvinyl alcohol KL-05 made by The NipponSynthetic Chemical Industry Co. Ltd. | 30 parts by weight |
| Malamine resin, Smirez Resin 613 made by Sumitomo Chemical Company Limited | 5 parts by weight |
| Blocked isocyanate, Coronate 2513 made by Nippon Polyurethane Industry, Co. | 10 parts by weight |
| Infrared ray absorbing dye CY-17 (a 10 % by weight solution in methanol) made by Nippon Kayaku, Co. | 10 parts by weight |
| Water | 70 parts by weight |

The above constituents were mixed and agitated together, and the resulting mixture was emulsified using a homomixer to provide a coating material 6.

The fabrication of a litho printing plate and estimation of printing were carried out in the same manner as in Example 1. As a result, the non-imaged area was smudged to a large extent, and good prints were not obtained.

The present invention is not limited to the above-described embodiments and examples, and various modifications in design may be made as required.

## Claims

1. A heat-sensitive recording-type material for a litho printing plate, comprising a heat-sensitive recording layer provided on a support, said heat-sensitive recording layer having a hydrophilic resin, an epoxy group-containing compound and a carboxylic compound with a carboxyl group protected by a vinyl ether as a thermally curing agent.

2. A heat-sensitive recording-type material for a litho printing plate according to claim 1, further including a light-heat converting agent provided in or outside said heat-sensitive recording layer.

3. A heat-sensitive recording-type material for a litho printing plate, comprising a heat-sensitive recording layer provided on a support, said heat-sensitive recording layer having a polymer of an unsaturated hydrophilic acid having a functional group comprising a carboxyl group protected by a vinyl ether.

4. A heat-sensitive recording-type material for a litho printing plate, comprising a heat-sensitive recording layer provided on a support, said heat-sensitive recording layer having a polymer of an unsaturated hydrophilic acid having a functional group comprising a carboxyl group protected by a vinyl ether, the surface of said heat-sensitive recording layer being treated by an aqueous solution of alkali having a pH value of 8 to 12 before being subjected to the printing.

5. A heat-sensitive recording-type material for a litho printing plate according to claim 3 or 4, further including a light-heat converting agent provided in or outside said heat-sensitive recording layer.

6. A process for producing a litho printing plate according to the present invention comprises the step of applying light to a heat-sensitive recording-type litho printing plate material according to claim 2 or 5 for a positive image or a negative image to heat a light-heat converting agent, thereby recording an image on said heat-sensitive recording layer to produce a litho printing plate.

7. A process for producing a litho printing plate comprises the steps of adding a thermally discolorable color matter of pigment in or outside a heat-sensitive recording layer of a heat-sensitive recording-type litho printing plate material according to any of claims 1, 2, 3, 4 and 5 to colorize the printing material, and applying a heat to cause an optical variation in concentration and a variation in hue attributable to a thermal discoloration, thereby forming an image to produce a litho printing plate.

8. A litho printing plate produced by a process for producing a litho printing plate according to claim 6 or 7.
